Europäisches Patentamt

(19) European Patent Office

Office européen des brevets

(11) Numéro de publication: **0 201 964**
**B1**

(12) **FASCICULE DE BREVET EUROPÉEN**

(45) Date de publication du fascicule du brevet:
28.02.90

(51) Int. Cl. ⁵: **H 03 F 3/195**

(21) Numéro de dépôt: 86200756.4

(22) Date de dépôt: 02.05.86

(54) Amplificateur pour hautes fréquences.

(30) Priorité: 10.05.85 FR 8507123

(43) Date de publication de la demande:
20.11.86 Bulletin 86/47

(45) Mention de la délivrance du brevet:
28.02.90 Bulletin 90/09

(54) Etats contractants désignés:
DE FR GB IT

(56) Documents cité:
EP-A-0 046 878

JAPANESE JOURNAL OF APPLIED PHYSICS, vol. 22,
no. 22-1, 1983, pages 129-132, Tokyo, JP; M. OHARA
et al.: "Very wide-band silicon bipolar monolithic
amplifiers"

IEEE TRANSACTIONS ON CONSUMER
ELECTRONICS, vol. CE-21, no. 4, novembre 1975,
pages 348-355, New York, US; W. HOEFT et al.: "A
monolithic if subsystem for demodulation of FM
signals"

(73) Titulaire: RTC-COMPELEC
130, Avenue Ledru-Rollin
F-75011 Paris (FR)
(84) Etats contractants désignés: FR

(73) Titulaire: N.V. Philips' Gloeilampenfabrieken
Groenewoudseweg 1
NL-5621 BA Eindhoven (NL)
(84) Etats contractants désignés: DE GB IT

(72) Inventeur: Barbu, Stefan SOCIETE CIVILE S.P.I.D.
209, rue de l'Université
F-75007 Paris (FR)

(74) Mandataire: Jacquard, Philippe
SOCIETE CIVILE S.P.I.D. 209, rue de l'Université
F-75007 Paris (FR)

## Description

La présente invention a pour objet un amplificateur pour hautes fréquences comportant au moins un étage différentiel comprenant un premier et un deuxième transistors dont les émetteurs, couplés entre eux, sont connectés à une première source de courant, dont les bases reçoivent des signaux d'entrée, et dont les collecteurs sont connectés respectivement aux émetteurs d'un troisième et d'un quatrième transistors dont les collecteurs sont reliés chacun à une source de tension d'alimentation respectivement par une première et une deuxième résistance de polarisation, les bases du troisième et du quatrième transistors étant reliées respectivement aux collecteurs du quatrième et du troisième transistor.

Un amplificateur du type, précité est connu de la demande de brevet allemand DE-A-3 121 314 (PHILIPS GLOEILAMPENFABRIEKEN) publiée le 22 avril 1982. Cette demande de brevet décrit un amplificateur pour hautes fréquences utilisable notamment pour alimenter un diviseur de fréquences et dans lequel la liaison entre les bases du troisième et du quatrième transistor et les collecteurs respectivement du quatrième et du troisième transistor est réalisée à travers une résistance de base dont la valeur est choisie ainsi que celle de la résistance de collecteur et du courant de polarisation à partir des formules données P.6 lignes 5 à 31, de manière à optimiser le comportement hautes fréquences, tout en permettant en même temps dans le meilleur des cas d'éliminer la composante continue (P.S lignes 15 à 19).

On connaît également des amplificateurs hautes fréquences à plusieurs étages, utilisables notamment comme amplificateurs d'entrée d'un diviseur de fréquence, et présentant un gain élevé, de l'ordre de 20 à 30 par exemple, dans la partie moyenne de la gamme de leurs fréquences utiles, mais ceci s'accompagne d'une bande passante réduite vers les plus hautes fréquences, pour lesquelles sa courbe de réponse présente une pente négative relativement élevée (-18 à 24 dB/octave). En effet, il est difficile avec de tels amplificateurs, d'obtenir des gains supérieurs à l'unité à la fréquence maximale d'utilisation de l'amplificateur dans le cas où celle-ci, par exemple de l'ordre du GHz, se rapproche sensiblement de la fréquence de coupure intrinsèque des transistors utilisés, par exemple lorsqu'elle atteint le cinquième ou éventuellement le tiers de cette fréquence de coupure. En effet, à ces fréquences, les transistors produisent des atténuations supplémentaires très gênantes. Il est par contre possible d'obtenir une bande passante étendue avec un amplificateur à un seul étage, mais le gain dans la partie moyenne de la bande passante est alors limité à une valeur de l'ordre de 4 ou 5 par exemple.

Si d'autre part, on associe en cascade deux étages de même type, l'amplificateur ainsi réalisé voit son gain devenir inférieur à 1 à une fréquence inférieure à celle pour laquelle un étage en tant que tel a son gain égal à 1. Ceci est dû au fait que l'impédance d'entrée de l'étage utilisé en sortie de l'amplificateur induit une atténuation supplémentaire de l'étage utilisé en entrée et qui s'ajoute aux atténuations précitées qui sont dûes aux transistors: Autrement dit, l'étage d'entrée, du fait de son couplage à l'étage de sortie a une bande passante moins étendue vers les fréquences élevées, et tout couplage s'avère délicat.

L'invention se propose de remédier à ces inconvénients et concerne à cet effet un amplificateur à large bande et à gain élevé pour hautes fréquences comportant deux étages différentiels en cascade, à savoir un étage d'entrée et un étage de sortie, et présentant un gain qui peut être cependant rendu supérieur à 1 pour une fréquence maximale d'utilisation de l'amplificateur, pouvant être nettement supérieure à 1 GHz par exemple 1,8 GHz, qui se rapproche sensiblement de la fréquence de coupure intrinsèque des transistors utilisés, par exemple 6 GHz, tout en présentant un gain élevé à des fréquences situées dans la partie moyenne de la gamme de ses fréquences utiles.

L'idée de base de l'invention consiste à assigner à chacun des deux étages, dont chacun présente un gain supérieur ou égal à 1 dans la gamme des fréquences utiles de l'amplificateur, les fonctions suivantes:

- l'étage d'entrée est un amplificateur résonnant, capable d'amplifier des signaux faibles et présentant un gain important à des fréquences situées dans la partie moyenne de la gamme de ses fréquences utiles ainsi qu'un gain maximal nettement supérieur à des fréquences situées dans le haut de la gamme de ses fréquences utiles, cette valeur plus élevée du gain maximal lui permettant de conserver une valeur de gain au moins égale à 1 à des fréquences élevées en dépit de la pente négative importante qu'il présente en raison de son couplage avec l'étage de sortie.
- l'étage de sortie est un amplificateur du type à "avance de phase" capable de travailler avec de forts signaux et d'apporter un gain important à des fréquences situées dans la partie moyenne de la gamme de ses fréquences utiles, et présentant une pente négative plus faible d'environ -6dB/octave aux fréquences élevées. Un amplificateur mettant en oeuvre le principe de l'avance de phase est décrit dans le brevet US 3 660 773 (fig. 1). Dans celui-ci l'avance de phase est obtenue par un condensateur pontant des résistances de contre-réaction d'émetteur d'un étage différentiel pour réduire leur effet de contre-réaction aux hautes fréquences.

Dans ce but, les étages de l'amplificateur selon l'invention sont réalisés de la manière suivante:

- l'étage d'entrée est constitué par un étage différentiel du type précité dans lequel la liaison entre les bases des troisième et du quatrième transistor avec respectivement les collecteurs du quatrième et du troisième transistors est directe,
- l'étage de sortie comprend un cinquième et un sixième transistors dont les bases sont connectées respectivement aux collecteurs du premier et du deuxième transistors, dont les collecteurs sont reliés chacun à ladite source de

2

tension d'alimentation respectivement par une troisième et une quatrième résistance de polarisation et dont les émetteurs sont reliés entre eux par un premier condensateur en parallèle avec un premier pont diviseur résistif dont le point milieu est connecté à une deuxième source de courant ;
- les éléments du premier pont diviseur résistif, le premier condensateur et les résistances de polarisation sont choisis de manière telle que l'amplificateur ait globalement un gain supérieur à 1 dans sa gamme de fréquences d'utilisation.

Selon une variante, les collecteurs des cinquième et sixième transistors sont chacun reliés à la base d'un transistor de sortie monté en émetteur suiveur.

Afin de limiter l'amplification de la composante continue des signaux d'entrée, l'amplificateur selon l'invention peut comporter un deuxième pont diviseur résistif, connecté entre le collecteur du cinquième transistor et la masse, et dont le point milieu, découplé par un deuxième condensateur, est relié à la base du premier transistor par l'intermédiaire d'une première résistance d'entrée, ainsi qu'un troisième pont diviseur résistif connecté entre le collecteur du sixième transistor et la masse, et dont le point milieu, découplé par un troisième condensateur est relié à la base du deuxième transistor par l'intermédiaire d'une deuxième résistance d'entrée.

On notera enfin que l'étage de sortie peut travailler en régime de saturation, et donc produire en sortie des signaux écrétés en réponse à des signaux d'entrée sinusoïdaux, et de ce fait d'assurer une fonction de mise en forme qui le rend particulièrement utilisable comme amplificateur d'entrée d'un diviseur de fréquence.

L'invention sera mieux comprise à la lecture de la description qui va suivre, donnée à titre d'exemple non limitatif, en liaison avec les figures qui représentent :

- la figure 1, un schéma de l'amplificateur selon l'invention,
- la figure 2, les courbes de réponse de chacun des deux étages dans la bande de fréquence utile de l'amplificateur
- la figure 3, un schéma équivalent de la boucle de limitation du gain de la composante continu du signal,
- la figure 4, un schéma équivalent de l'impédance d'entrée de l'étage de sortie.
- la figure 5, la courbe de réponse de l'amplificateur.

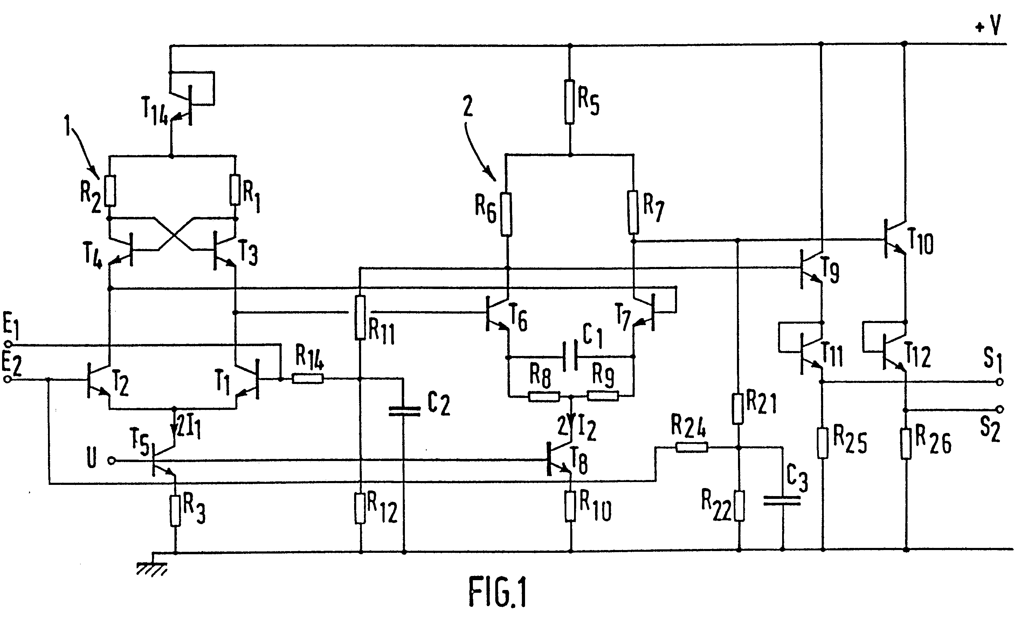

Selon la figure 1, l'étage d'entrée de l'amplificateur comporte un étage différentiel à deux transistors $T_1$ et $T_2$ couplés par les émetteurs, ceux-ci étant connectés à une source de courant constituée par un transistor $T_5$ dont l'émetteur est relié à la masse par une résistance R3, la base du transistor $T_5$ recevant une tension de commande U qui fixe le courant $2I_1$ délivré par la source de courant.

Les entrées $E_1$ et $E_2$ de l'amplificateur sont constituées respectivement par les bases des transistors $T_1$ et $T_2$. Deux transistors $T_3$ et $T_4$ formant le circuit résonnant de l'étage d'entrée ont leurs émetteurs reliés respectivement aux collecteurs des transistors $T_1$ et $T_2$, la base du transistor $T_3$ étant connectée au collecteur du transistor $T_4$ et vice-versa. Les collecteurs des transistors $T_3$ et $T_4$ sont reliés à une source de tension d'alimentation à travers des résistances de polarisation respectivement $R_1$ et $R_2$ d'égale valeur. Cette source de tension est figurée par une alimentation +V dont le potentiel est abaissé d'une tension émetteur-base (environ 0,8 V) par un transistor $T_{14}$ monté en diode dont le collecteur et la base sont à cet effet connectés ensemble à l'alimentation +V, et l'émetteur à la borne commune des résistances $R_1$ et $R_2$.

L'étage de sortie comporte un étage différentiel à deux transistors $T_6$ et $T_7$ dont les émetteurs sont reliés entre eux par un condensateur $C_1$ en parallèle avec un pont résistif ($R_8$, $R_9$) dont le point milieu est connecté à une source de courant constituée par un transistor $T_8$ dont l'émetteur est relié à la masse par une résistance $R_{10}$, la base du transistor $T_8$ recevant la tension de commande U qui fixe le courant $2I_2$ délivré par la source de courant. Les résistances $R_8$ et $R_9$ et le condensateur $C_1$ forment un circuit d'avance de phase permettant d'améliorer le gain de l'étage de sortie dans le haut de la gamme des fréquences utiles.

La base des transistors $T_6$ et $T_7$ reçoit les signaux de sortie de l'étage d'entrée délivrés par le collecteur respectivement des transistors $F_1$ et $T_2$. Le collecteur des transistors $T_6$ et $T_7$ sont reliés à une source de tension d'alimentation à travers des résistances respectivement $R_6$ et $R_7$. Cette source de tension se présente sous la forme d'une alimentation V dont la tension est abaissée par une résistance $R_5$ disposée en série entre l'alimentation V et le point commun aux résistances $R_6$ et $R_7$, et qui est donc toujours parcourue par le courant $2I_2$.

Les sorties de l'étage de sortie sont constituées par les collecteurs des transistors $T_6$ et $T_7$ et peuvent être utilisés directement. On a représentés des transistors $T_9$ et $T_{10}$ montés en émetteur suiveur, dont le collecteur est connecté à l'alimentation V, la base respectivement au collecteur des transistors $T_6$ et $T_7$ et l'émetteur à des transistors $T_{11}$ et $T_{12}$ montés en diode dans le sens direct, ce qui produit globalement un décalage de deux tensions base-émetteur (1,6V environ). A cet effet, les transistors $T_{11}$ et $T_{12}$ ont leur collecteur court-circuité à leur base et connecté respectivement à l'émetteur des transistors $T_9$ et $T_{10}$. Les émetteurs des transistors $T_{11}$ et $T_{12}$, relié à la masse respectivement à travers des résistances $R_{25}$ et $R_{26}$, constituent les sorties respectivement $S_1$ et $S_2$ de l'amplificateur.

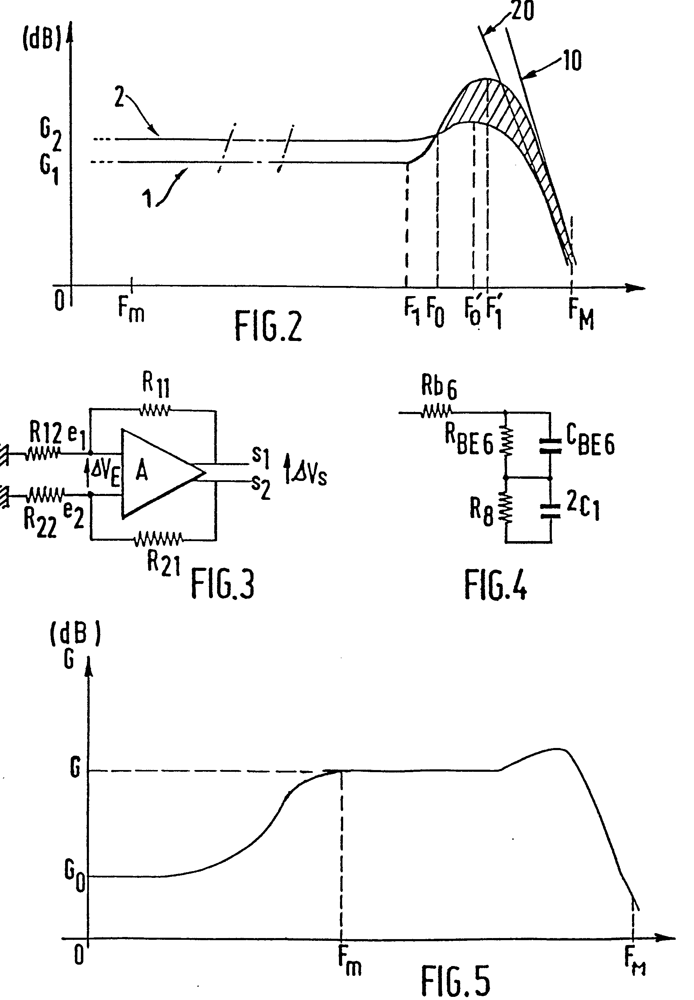

La figure 2 montre l'allure des courbes de réponses de l'étage d'entrée couplé à l'étage de sortie et de l'étage de sortie dans la bande des fréquences utiles de l'amplificateur, entre une fréquence minimale $F_m$ et une fréquence maximale $F_M$.

La courbe de réponse de l'étage d'entrée 1 couplé à l'étage de sortie présente dans la gamme inférieure des fréquences de l'amplificateur un gain sensiblement constant $G_1$. Le gain devient sous l'effet du circuit résonnant nettement plus élevé à partir d'une fréquence $F_1$ jusqu'à une fréquence d'anti- résonance $F'_1$ corres-

pondant à un gain maximal, au-dessus de laquelle le gain diminue à nouveau pour rejoindre une asymptote 10 de pente -12dB/octave, le gain restant supérieur ou égal à 1 (OdB) à la fréquence maximale $F_M$).

La courbe de réponse de l'étage de sortie 2 présente dans la gamme inférieure des fréquences de l'amplificateur un gain sensiblement constant $G_2$ qui peut être voisin de $G_1$. Le gain devient sous l'effet du circuit d'avance de phase légèrement plus élevé à partir d'une fréquence $F_0$ jusqu'à une fréquence $F'_0$ au dessus de laquelle le gain diminue à nouveau pour rejoindre une asymptote 20 de pente -6 dB/octave, le gain restant supérieur ou égal à 1 (OdB) à la fréquence maximale $F_M$ choisie.

Dans la partie inférieure de la gamme utile des fréquences de l'amplificateur, les deux étages ont des gains voisins ($G_1 \sim G_2$) jusqu'à une fréquence $F_1$ à partir de laquelle l'étage d'entrée commence à avoir un gain plus important sous l'éffet du circuit résonnant précité (zone hachurée). Du fait que l'asymptote 10 de la courbe 1 a une pente plus forte que celle 20 de la courbe 2, il existe une fréquence de croisement, qui peut être inférieure ou de préférence supérieure à $F_M$.

Nous allons maintenant expliquer comment il convient de choisir les paramètres du circuit pour obtenir les courbes de réponse mentionnés ci-dessus. A cet effet, on utilise à titre d'illustration un exemple avec $F_m \sim 40$ MHz et $F_M = 1GHz$, correspondant au cas d'un amplificateur d'entrée destiné à un diviseur de fréquence utilisable dans un récepteur de télévision fonctionnant dans cette bande de fréquences.

La demanderesse pense que la courbe de réponse $G_1(s)$ de l'étage d'entrée seul, c'est-à-dire non couplé à l'étage de sortie peut être représentée en première approximation par la formule suivante:

$$G_1(s) = \frac{G_1(1-sT_1)}{(1+sT_2)(1+sT_3)}$$

$$\text{avec } G_1 = \frac{R_1 I_1}{V_T}$$

$$T_1 = C_{BC}[4R_1 + R_b(1 + G_1)] = \frac{1}{2 \pi F_1}$$

$$T_2 = C_{BC}(R_b + R_1) = \frac{1}{2 \pi F_2}$$

$$T_3 = K C_{BE}\frac{V_T}{I_1} = \frac{1}{2\pi F_3} \text{ avec } K \sim 4 \text{ et } V_t = 26 \text{ mV}$$

$C_{BC}$ et $C_{BE}$ représentent respectivement les capacités base-collecteur et base-émetteur des transistors $T_3$ et $T_4$, et $R_b$ la résistance intrinsèque de base des mêmes transistors.

On a toujours $T_1 > T_2$. La relation $T_2 > T_3$ est également toujours vérifiée car $C_{BE} \sim 2C_{BC}$ pour les transistors utilisés en technologie intégrée et le terme $\frac{V_T}{I_1}$ est petit ($I_1 \sim$ 1mA) par rapport à $R_b + 4R_1$ d'où:

$$F_1 < F_2 < F_3.$$

L'allure de la courbe 1 de la figure 2 est donc une propriété caractéristique du schéma éléctrique de l'étage d'entrée.

Pour plus de renseignements sur la modélisation des transistors aux très hautes fréquences, on pourra se reporter à l'ouvrage de P.R.GRAY et R.G.MEYER "Analysis and Design of Analog Integrated Circuits" (ed. John Wiley and sons USA-1977).

Avec un type de transistor présentant une fréquence de coupure intrinsèque $f_T$ de l'ordre de 5GHz, on a ainsi obtenu avec $R_1 = 100 \ \Omega$ et $I_1 = 1mA$ et donc $G_1 \sim 4$, les valeurs suivantes:

$$F_1 \sim 300 \text{ Mhz}, F_2 \sim 540 \text{ Mhz}, F_3 \sim 900 \text{ Mhz}.$$

On notera que le choix d'une valeur élevée pour $G_1$ a pour effet d'abaisser la valeur de $F_3$. Le réglage optimal consiste à ajuster les différents paramètres pour que $F_M$ soit le plus grand possible (les deux étages une fois couplés).

Lorsque l'étage d'entrée est couplé à l'étage de sortie, les valeurs de $T_1$, $T_2$ et $T_3$ sont légèrement modifiées et la courbe $G(s)$ tend pour les fréquences supérieures à $F_3$ vers une asymptote à -18 dB/octave. Dans l'exemple ci-dessus, la fréquence $F_M$ pour laquelle l'étage d'entrée a un gain de 1 est nettement supérieure à 1Ghz. On remarquera également qu'au voisinage de $F_M$, une atténuation supplémentaire intervient du fait que la fréquence de coupure $f_T$ est abaissée par le montage des transistors dans un circuit.

Dans la partie moyenne et inférieure de la bande des fréquences utiles, le rétro-couplage des transistors $T_3$

et $T_4$ est sans effet et le gain a la valeur $G_1$ qui se calcule comme pour un étage différentiel classique.

$$G_1 = \frac{R_1 I_1}{V_T}$$

L'impédance du deuxième étage telle qu'elle est vue par une sortie du premier étage est schématisée à la figure 4. Elle consiste en la résistance de base intrinsèque $R_{b6}$ du transistor $T_6$ en série avec d'une part la résistance base-émetteur $R_{BE6}$ de $T_6$ et la résistance $R_8$, la capacité base-émetteur $C_{BE6}$ de $T_6$ étant aux bornes de $R_{BE6}$ et un condensateur de valeur $2C_1$ aux bornes de $R_8$.

La courbe de réponse $G'(s)$ du deuxième étage peut s'exprimer par la formule:

$$G'(s) = \frac{G_2 (1 + sT_0)}{(1 + sT_4)(1 + sT_5)} \quad \text{avec } T_0 = 2 R_8 C_1$$

d'où

$$F_0 = \frac{1}{4 \pi R_8 C_1}$$

et avec $R_6 = R_7$

$$G_2 = \frac{R_6 I_c}{V_T + R_8 I_2} = \frac{R_6}{R_8}$$

Par exemple pour $C_1 = 2,5$ pF, $R_6 = 360\ \Omega$ et $R_8 = 80\ \Omega$, on a $G_2 = 4,5$ et $F_0$ 400 MHz.

Il convient cependant de noter que le réglage de l'amplificateur ne peut être optimal que si le réglage des deux étages est réalisé lorsque les deux étages sont couplés entre eux, l'étage de sortie étant lui-même de préférence relié au circuit qu'il doit alimenter. En effet, l'impédance d'entrée de l'étage de sortie modifie considérablement ainsi qu'on l'a mentionné plus haut, les caractéristiques hautes fréquences de l'étage d'entrée.

Une bonne approximation pour le réglage global de l'amplificateur consiste à déterminer tout d'abord les paramètres de l'étage d'entrée en tant que tel comme indiqué ci-dessus, à choisir le gain désiré $G_2$ de l'étage de sortie en fixant un rapport $\frac{R7}{R9} = \frac{R6}{R8}$, à choisir la fréquence Fr voisine de la fréquence $F_1$ de l'étage d'entrée, et à faire varier les valeurs de $R_8 = R_9$ et de $C_1$ en maintenant constant le rapport $\frac{R7}{R9} = \frac{R6}{R8}$ et le produit $R_8C_1$ jusqu'à obtenir une fréquence maximale correspondant à un gain de 1 (0dB) ceci correspondant à une adaptation des deux étages entre eux.

Selon un mode de réalisation préféré, l'amplificateur présente un circuit introduisant un couplage entre sa sortie et son entrée pour limiter le gain en continu.

A cet effet, le collecteur du transistor $T_6$ est relié à la masse par un premier pont diviseur comportant deux résistances $R_{11}$ et $R_{12}$, un condensateur $C_2$ étant connecté aux bornes de la résistance $R_{12}$, entre le point milieu du pont diviseur et la masse. Le point milieu du pont diviseur est relié à la base du transistor $T_1$ à travers une résistance d'entrée $R_{14}$. De même, le collecteur du transistor $T_7$ est relié à la masse par un deuxième pont diviseur comportant deux résistances $R_{21}$ et $R_{22}$, un condensateur $C_3$ étant connecté aux bornes de la résistance $R_{22}$, entre le point milieu du deuxième pont diviseur et la masse. Le point milieu du pont diviseur est relié à la base du transistor $T_2$ à travers une résistance d'entrée $R_{24}$.

$R_{12}$, $R_{22}$, $C_2$ et $C_3$ sont choisis de telle manière que, dans la bande utile de l'amplificateur, $C_2 = C_3$ agissent comme un court-circuit, ce qui fait qu'à ces fréquences, tout se passe comme si $R_{14}$ et $R_{24}$ étaient branchées entre la base respectivement de $T_1$ et $T_2$ et la masse. $R_{14}$ et $R_{24}$ déterminent donc l'impédance d'entrée de l'étage d'entrée. On prend par exemple $R_{14} = R_{24} = 500\Omega$.

En dessous d'une fréquence $F_8 = \frac{1}{2\pi R_{12}C_2} = \frac{1}{2\pi R_{22}C_3}$

on obtient une diminution du gain de l'amplificateur jusqu'à une valeur $G_0$ (voir fig. 5) égale à $1 + \frac{R_{11}}{R_{12}} = 1 + \frac{R_{21}}{R_{22}}$

qui est la valeur du gain obtenu pour la composante continue du signal. Pour obtenir un gain inférieur à 2, on prend $R_{11} < R_{12}$. En effet, pour le courant continu, les condensateurs $C_2$ et $C_3$ se chargent à travers respectivement les résistances $R_{14}$ et $R_{24}$. Les bornes de $R_{14}$ sont toutes les deux au potentiel $e_1$ et celles de $R_{24}$ au potentiel $e_2$. De ce fait, le schéma équivalent est celui de la figure 3, sous la forme d'un amplificateur A à deux entrées $e_1$ et $e_2$ et deux sorties $s_1$ et $s_2$, la résistance $R_{12}$ étant disposée entre $e_1$ et la masse, la résistance $R_{22}$ entre $e_2$ et la masse, la résistance $R_{11}$ entre s et $e_1$ et la résistance $R_{21}$ entre s et $e_2$.

La condition d'équilibre des courants dans chacune des branches donne la valeur du gain mentionnée ci-dessus.

Par exemple, pour $R_{11} = R_{21} = 5,4 \ k\Omega$, $R_{12} = R_{22} = 7,4 k\Omega$, $C_2 = C_3 = 1pF$, on a Fm $\sim\_42MHz$ et $G_0 = 1,73$ pour un gain global de l'amplificateur de $G = G_1 \simeq G_2$ 18, en conservant les valeurs des exemples ci-dessus.

Une fonction de mise en forme des signaux peut être réalisée par l'étage de sortie, par écrêtage des signaux sinusoïdaux (fonctionnement en régime de saturation). Il suffit pour cela de choisir la tension d'alimentation de l'étage de sortie, par exemple en choisissant la valeur de la résistance $R_5$, pour que, étant donné le gain G obtenu, l'écrêtage se produise pour les signaux d'entrée $E_1$, $E_2$ de niveau le plus faible qui soient prévus dans les conditions d'utilisation de l'amplificateur.

## Revendications

1. Amplificateur pour hautes fréquences comportant au moins un étage différentiel comprenant un premier et un deuxième transistors dont les émetteurs, couplés entre eux, sont connectés à une première source de courant, dont les bases reçoivent des signaux d'entrée et dont les collecteurs sont connectés respectivement aux émetteurs d'un troisième et d'un quatrième transistors, dont les collecteurs sont reliés chacun à une source de tension d'alimentation respectivement par une première et une deuxième résistance de polarisation, les bases du troisième et du quatrième transistors étant reliées respectivement aux collecteurs du quatrième et du troisième transistor, caractérisé en ce que ledit étage différentiel constitue un étage différentiel d'entrée, en ce que la liaison entre les bases des troisième ($T_3$) et du quatrième ($T_4$) transistors avec respectivement les collecteurs du quatrième ($T_4$) et du troisième ($T_3$) transistors est directe, en ce qu'il comporte:

- un étage de sortie comprenant un cinquième ($T_6$) et un sixième ($T_7$) transistors dont les bases sont connectées respectivement aux collecteurs du premier ($T_1$) et du deuxième ($T_2$) transistors, dont les collecteurs sont reliés chacun à ladite source de tension d'alimentation respectivement par une troisième ($R_6$) et une quatrième ($R_7$) résistance de polarisation, et dont les émetteurs sont reliés entre eux par un premier condensateur ($C_1$) en parallèle avec un premier pont diviseur résistif ($R_8$, $R_9$) dont le point milieu est connecté à une deuxième source de courant ($R_{10}$, $T_8$), et en ce que les éléments ($R_8$, $R_9$) du premier pont diviseur résistif, le premier condensateur ($C_1$) et les résistances de polarisation sont choisis de manière telle que l'amplificateur ait globalement un gain supérieur à 1 dans sa gamme de fréquences d'utilisation.

2. Amplificateur selon la revendication 1, caractérisé en ce que ledit choix est tel que l'amplificateur ait également un gain supérieur à une valeur nominale donnée à sa fréquence minimale d'utilisation.

3. Amplificateur selon une des revendications 1 ou 2 caractérisé en ce que les collecteurs des cinquième ($T_6$ et sixième ($T_7$) transistors sont chacun reliés à la base d'un transistor de sortie ($T_9$, $T_{10}$) monté en émetteur suiveur.

4. Amplificateur selon une des revendications 1 à 3 caractérisé en ce que, pour limiter l'amplificateur de la composante continue des signaux d'entrée ($E_1$, $E_2$), il comporte un deuxième pont diviseur résistif ($R_{11}$, $R_{12}$), connecté entre le collecteur du cinquième transistor ($T_6$) et la masse, et dont le point milieu, découplé par un deuxième condensateur ($C_2$), est relié à la base du premier transistor ($T_1$) par l'intermédiaire d'une première résistance d'entrée ($R_{14}$), ainsi qu'un troisième pont diviseur résistif ($R_{21}$, $R_{22}$) connecté entre le collecteur du sixième transistor ($F_7$) et la masse, et dont le point milieu, découplé par un troisième condensateur ($C_3$), est relié à la base du deuxième transistor ($T_2$) par l'intermédiaire d'une deuxième résistance d'entrée ($R_{24}$).

5. Amplificateur selon une des revendications précédentes caractérisé en ce que son gain est tel que, pour les signaux d'entrée d'un niveau supérieur à un niveau minimal nominal, l'étage de sortie fonctionne en régime de saturation, de telle sorte qu'à des signaux d'entrée sinusoïdaux correspondent en sortie des signaux écrêtés.

## Claims

1. A high-frequency amplifier comprising at least one differential stage which comprises a first and a second transistor whose emitters, which are coupled to each other, are connected to a first current source, whose bases receive the input signals, and whose collectors are connected to the emitter of a third transistor and of a fourth transistor respectively, whose collectors are each connected to a supply-voltage source by a first bias resistor and a second bias resistor respectively, the bases of the third transistor and the fourth transistor being connected to the collectors of the fourth transistor and the third transistor respectively, characterized in that said differential stage constitutes a differential input stage, in that the bases of the third transistor ($T_3$) and the fourth transistor ($T_4$) are connected directly to the collectors of the fourth transistor ($T_4$) and the third transistor ($T_3$) respectively, in that it comprises:

- an output stage which comprises a fifth transistor ($T_6$) and a sixth transistor ($T_7$) whose bases are connected to collectors of the first transistor ($T_1$) and the second transistor ($T_2$) respectively, whose collectors are each connecte6 to said supply-voltage source by a third bias resistor ($R_6$) and a fourth bias resistor ($R_7$), and whose emitters are connected to each other by a first capacitor ($C_1$) in parallel with a first resistive divider bridge ($R_8$, $R_9$) whose centre is connected to a second current source ($R_{10}$, $T_8$), and in that the elements ($R_8$, $R_9$) of the first resistive divider bridge, the first capacitor ($C_1$) and the bias resistors are chosen in such a way that the amplifier has an overall gain higher than 1 in its operating frequency range.

2. An amplifier as claimed in claim 1, characterized in that said choice is such that the amplifier also has a gain higher than a given nominal value at its minimum operating frequency.

3. An amplifier as claimed in claim 1 or 2, characterized in that the collectors of the fifth transistor ($T_6$) and the sixth transistor ($T_7$) are each connected to the base of an output transistor ($T_9$, $T_{10}$) arranged as an emitter follower.

4. An amplifier as claimed in any one of the Claims 1 to 3, characterized in that, for limiting the gain for the d.c. component of the input signals ($E_1$, $E_2$), the amplifier comprises a second resistive divider bridge ($R_{11}$, $R_{12}$) which is arranged between the collector of the fifth transistor ($T_6$) and earth and has its centre, which is decoupled by means of a second capacitor ($C_2$), connected to the base of the first transistor ($T_1$) via a first input resistor ($R_{14}$), and a third resistive divider bridge ($R_{21}$, $R_{22}$) which is arranged between the collector of the sixth transistor ($T_7$) and earth and has its centre, which is decoupled by means of a third capacitor ($C_3$), connected to the base of the second transistor ($T_2$) via a second input resistor ($R_{24}$).

5. An amplifier as claimed in any one of the preceding claims, characterized in that its gain is such that for input signals of a level higher than a nominal minimum level the output stage operates in the saturated mode, in such a way that sinusoidal input signals yield clipped output signals.

## Patentansprüche

1. Hochfrequenzverstärker mit wenigstens einer differentiellen Stufe, die einen ersten und einen zweiten Transistor enthält, deren miteinander verbundene Emitter an eine erste Stromquelle angeschlossen sind, deren Basen Eingangssignale empfangen und deren Kollektoren an die Emitter eines dritten bzw. eines vierten Transistors angeschlossen sind, deren Kollektoren je mit einer Speisespannungsquelle über einen ersten bzw. einen zweiten Polarisationswiderstand verbunden sind, wobei die Basen des dritten und des vierten Transistors mit den Kollektoren des vierten bzw. des dritten Transistors verbunden sind, *dadurch gekennzeichnet*, daß die differentielle Stufe eine differentielle Eingangsstufe darstellt, daß die Verbindung zwischen den Basen des dritten ($T_3$) und des vierten ($T_4$) Transistors mit den Kollektoren des vierten ($T_4$) und des dritten ($T_3$) Transistors unmittelbar ist, daß der Verstärker außerdem enthält

- eine Ausgangsstufe mit einem fünften ($T_6$) und einem sechsten ($T_7$) Transistor, deren Basen mit den Kollektoren des ersten ($T_1$) bzw. des zweiten ($T_2$) Transistors verbunden sind, deren Kollektoren je mit der Speisespannungsquelle über einen dritten ($R_6$) bzw. einen vierten ($R_7$) Polarisationswiderstand verbunden sind und deren Emitter über einen Kondensator ($C_1$) in Parallelschaltung mit einer ohmischen Teilerbrücke ($R_8$, $R_9$) miteinander verbunden sind, deren Mittelanzapfung mit einer zweiten Stromquelle ($R_{10}$, $T_8$) verbunden ist, und daß die Elemente ($R_8$, $R_9$) der ersten ohmischen Teilerbrücke, der erste Kondensator ($C_1$) und die Polarisationswiderstände derart gewählt sind, daß der Verstärker in seinem Benutzungs-Frequenzbereich im großen ganzen einen höheren Verstärkungsgrad als 1 hat.

2. Verstärker nach Anspruch 1, *dadurch gekennzeichnet*, daß diese Wahl derart getroffen wird, daß der Verstärker einen höheren Verstärkungsgrad als der durch seine Benutzungs-Mindestfrequenz angegebene Nennwert ist.

3. Verstärker nach Anspruch 1 oder 2, *dadurch gekennzeichnet*, daß die Kollektoren des fünften ($T_6$) und sechsten ($T_7$) Transistors je mit der Basis eines als Emitterfolger geschalteten Ausgangstransistors ($T_9$, $T_{10}$) verbunden sind.

4. Verstärker nach einem der Ansprüche 1 bis 3, *dadurch gekennzeichnet*, daß zum Begrenzen der Verstärkung des Gleichanteils der Eingangssignale ($E_1$, $E_2$) eine zweite ohmische Teilerbrücke ($R_{11}$, $R_{12}$), die zwischen dem Kollektor des fünften Transistors ($T_6$) und der Masse angeschlossen und deren von einem zweiten Kondensator ($C_2$) entkoppelte Mittelanzapfung mit der Basis des ersten Transistors ($T_1$) über einen ersten Eingangswiderstand ($R_{14}$) verbunden ist, und eine dritte ohmische Teilerbrücke ($R_{21}$, $R_{22}$) vorgesehen sind, die zwischen dem Kollektor des sechsten Transistors ($T_7$) und der Masse angeschlossen ist, und deren von einem dritten Kondensator ($C_3$) entkoppelte Mittelanzapfung ist mit der Basis des zweiten Transistors ($T_2$) über einen zweiten Eingangswiderstand ($R_{24}$) verbunden.

5. Verstärker nach einem der vorangehenden Ansprüche, *dadurch gekennzeichnet*, daß sein Verstärkungsgrad für die Eingangssignale eines höheren Pegels als eines minimalen Nennpegels derart ist, daß die Ausgangsstufe derart im Sättigungsbetrieb arbeitet, daß sinusoidalen Eingangssignalen am Ausgang abgeschnittene Signale entsprechen.

FIG.1

FIG.2

FIG.3

FIG.4

FIG.5